# EUROPÄISCHE PATENTSCHRIFT

(11) **EP 2 294 614 B1**
(45) Veröffentlichungstag und Bekanntmachung des Hinweises auf die Patenterteilung: **22.11.2017**
(21) Anmeldenummer: 09771994.2
(22) Anmeldetag: 18.06.2009
(51) Int. Cl.: H01L 25/075, H05B 33/10

(54) **VERFAHREN ZUR HERSTELLUNG EINER VIELZAHL VON OPTOELEKTRONISCHEN BAUELEMENTEN**
METHOD FOR PRODUCING A PLURALITY OF OPTOELECTRONIC COMPONENTS
PROCÉDÉ DE PRODUCTION DE PLUSIEURS COMPOSANTS OPTOÉLECTRONIQUES

(30) Priorität: 30.06.2008 DE 102008030815
(43) Veröffentlichungstag der Anmeldung: 16.03.2011
(73) Patentinhaber: OSRAM Opto Semiconductors GmbH, 93055 Regensburg (DE)
(72) Erfinder: HERRMANN, Siegfried, 94362 Neukirchen (DE)
(74) Vertreter: Epping - Hermann - Fischer
(86) Internationale Anmeldenummer: PCT/DE2009/000857
(87) Internationale Veröffentlichungsnummer: WO 2010/000224

(56) Entgegenhaltungen:
- EP-A- 1 592 074
- DE-A1- 10 245 930
- DE-C1- 10 128 271
- US-A1- 2002 093 026
- US-A1- 2007 126 016

## Beschreibung

Die Erfindung betrifft ein Verfahren zur Herstellung einer Vielzahl von optoelektronischen Bauelementen.

Für die Herstellung von optoelektronischen Bauelementen, die nach der Herstellung auf einem Anschlussträger befestigt und kontaktiert werden sollen, sind oftmals eine Reihe von Einzelbearbeitungsschritten erforderlich, die insbesondere zur Herstellung eines jeden Bauelements einzeln durchgeführt werden müssen.

Einzelbearbeitungsschritte, also Schritte, die für jedes Bauelement gesondert durchgeführt werden, sind jedoch im Vergleich zu Bearbeitungsschritten, welche gleichzeitig für eine Vielzahl von Bauelementen durchgeführt werden können, kostenintensiv und aufwändig.

Patentschrift DE 101 28 271 C1 offenbart ein Verfahren zur Herstellung einer Vielzahl von optoelektronischen Bauelementen gemäß des Oberbegriffs des Anspruchs 1.

Eine Aufgabe der vorliegenden Erfindung ist es, ein Verfahren zur Herstellung einer Vielzahl optoelektronischer Bauelemente anzugeben, welches vereinfacht herstellbar ist.

Diese Aufgabe wird durch ein Verfahren zur Herstellung einer Vielzahl von optoelektronischen Bauelementen gemäß Anspruch 1 gelöst, das die folgenden Schritte umfasst:
- Bereitstellen eines Halbleiterkörperträgers, der auf einer ersten Hauptfläche eine Vielzahl von jeweils mit einer Kontaktstruktur versehenen Halbleiterkörper mit einer zur Erzeugung von elektromagnetischer Strahlung geeigneten aktiven Schicht in einer Halbleiterschichtenfolge umfasst, und
- Bilden einer planaren Füllstruktur auf der ersten Hauptfläche, wobei die planare Füllstruktur Bereiche auf der Kontaktstruktur und dem Halbleiterkörperträger wenigstens teilweise abdeckt, ohne den Halbleiterkörper zu bedecken.

Gemäß der Erfindung wurde ein Herstellungskonzept für optoelektronische Bauelemente angegeben, bei dem der Aufbau von einzelnen optoelektronischen Bauelementen oder von zu einem Modul zusammengefassten mehreren optoelektronischen Bauelementen auf Waferlevelebene erfolgt. Dies bedeutet, dass die auf einem Halbleiterkörperträger angeordneten optoelektronischen Halbleiterkörper mittels einer Füllstruktur mit einem Gehäuse versehen werden.

Dazu kann beispielsweise eine Chipummantelung gebildet werden, die aus einem heterogenen Kunststoff besteht, der keramikähnliche Eigenschaften hat, wie zum Beispiel Epoxy-Silizium-Gemische. Es ist aber auch denkbar, eine Vergussmasse zu verwenden, die aus einem Kunststoff-Festkörperpulvergemisch besteht. Charakteristisch für das Herstellungskonzept ist es, dass die Füllstruktur eine planare Schicht bildet.

Dies erleichtert nachfolgende Prozessschritte, wie zum Beispiel das elektrische Verschalten der Halbleiterkörper, das Aufbringen eines Konverters oder das Bilden von optischen Elementen, wie zum Beispiel Linsen. Diese Prozessschritte können alle auf Waferlevelebene durchgeführt werden, sodass die eingangs erwähnten, zeitaufwändigen Einzelbearbeitungsschritte größtenteils eingespart werden können.

In einer weiteren Ausgestaltung wird der Schritt des Bildens der planaren Füllstruktur dadurch ausgeführt, dass eine strukturierte Resistschicht gebildet wird, die zumindest den Halbleiterkörper bedeckt, die planare Füllstruktur außerhalb der strukturierten Resistschicht gebildet wird und die strukturierte Resistschicht anschließend entfernt wird.

Demgemäß wird die als Gehäuse dienende Füllstruktur mittels eines lithografischen Herstellungsverfahrens gebildet, das es erlaubt, die bei der Herstellung von Halbleiterkörpern gewohnte lithografische Präzision auch auf die Herstellung von Gehäuseummantelungen auszuweiten.

In einer weiteren Ausgestaltung wird der Halbleiterkörper als Lumineszenzdiodenchip, vorzugsweise als Dünnfilm-Lumineszenzdiodenchip, hergestellt.

Bei der Herstellung eines Dünnfilm-Lumineszenzdiodenchips wird eine funktionelle Halbleiterschichtenfolge, die insbesondere eine strahlungsemittierende aktive Schicht umfasst, zunächst epitaktisch auf einem Aufwachssubstrat aufgewachsen, anschließend ein neuer Träger auf die dem Aufwachssubstrat gegenüberliegende Oberfläche der Halbleiterschichtenfolge aufgebracht und nachfolgend das Aufwachssubstrat abgetrennt. Da insbesondere die für Nitridverbindungshalbleiter verwendeten Aufwachssubstrate, beispielsweise SiC, Saphir oder GaN vergleichsweise teuer sind, bietet dieses Verfahren insbesondere den Vorteil, dass das Aufwachssubstrat wieder verwertbar ist. Das Ablösen eines Aufwachssubstrats aus Saphir von einer Halbleiterschichtenfolge aus einem Nitridverbindungshalbleiter kann beispielsweise mit einem Lift-Off-Verfahren erfolgen.

Insbesondere kann der Lumineszenzdiodenchip eine Epitaxie-Schichtenfolge aufweisen, die auf einem III-V-Verbindungshalbleitermaterial, bevorzugt Nitridverbindungshalbleiter, aber auch Phosphid-Verbindungshalbleitermaterialien oder Arsenid-Verbindungshalbleitermaterialien, basiert.

"Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₓGa_{y}In_{1-x-y}N umfasst, wobei 0 ≤ x ≤ 1, 0 ≤ y ≤ 1 und x + y ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₓGa_{y}In_{1-x-y}N-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass der aktive Bereich, insbesondere der Halbleiterkörper, vorzugsweise AlₙGaₘInₗ₋ₙ₋ₘP umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass der aktive Bereich, insbesondere der Halbleiterkörper, vorzugsweise AlₙGaₘInₗ₋ₙ₋ₘAs umfasst oder daraus besteht, wobei 0 ≤ n ≤ 1, 0 ≤ m ≤ 1 und n+m ≤ 1 ist, vorzugsweise mit n ≠ 0, n ≠ 1, m ≠ 0 und/oder m ≠ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, As), auch wenn diese teilweise durch geringe Mengen weiterer Stoffe ersetzt sein können.

In einer weiteren Ausgestaltung umfasst der Schritt des Bereitstellen des Halbleiterkörperträgers, dass die Vielzahl von auf einem Halbleiterkörperträger aufgebrachten Halbleiterkörper von einem Waferverbund einzeln auf den Halbleiterkörperträger übertragen werden.

Demgemäß kann der Halbleiterkörperträger mit der Vielzahl von Halbleiterkörpern optoelektronische Chipsegmente aus unterschiedlichen Wafern aufnehmen und zu einem neuen Verbund zusammensetzen. Dies ist insbesondere vorteilhaft, um Variationen im Abstrahlverhalten unterschiedlicher Halbleiterkörper, Ausbeuteverluste oder ähnliches auszugleichen. So ist es zum Beispiel möglich, die Vielzahl der Halbleiterkörper vorher zu testen, beispielsweise mittels eines Wafertester, sodass die Abstrahlcharakteristik des optoelektronischen Bauelements gewisse Spezifikationen erfüllt.

Eine weitere Möglichkeit besteht nun darin, Halbleiterkörper aus unterschiedlichen Halbleiterwafern auf dem Halbleiterkörperträger anzuordnen, sodass Module mit unterschiedlichen Farbeindrücken oder RGB-Module erzeugt werden können. Dazu können beispielsweise die in der Technik bekannte Pick-and-Place-Technologien verwendet werden.

In einer weiteren Ausgestaltung umfasst der Schritt des Bereitstellens des Halbleiterkörperträgers, dass die Vielzahl von auf dem Halbleiterkörperträger aufgebrachten Halbleiterkörper von einem Waferverbund mittels eines Hilfsträgers gemeinsam auf den Halbleiterkörperträger übertragen werden.

Dazu kann beispielsweise eine Folie vorgesehen sein, die auf einem Wafer hergestellte Halbleiterkörper übernimmt und auf dem Halbleiterkörperträger absetzt.

Vorteilhafte Ausgestaltungen und Weiterbildungen der Erfindung sind Gegenstand der abhängigen Patentansprüche.

Die Erfindung wird nachfolgend an mehreren Ausführungsbeispielen anhand der Figuren näher erläutert.

Funktions- beziehungsweise wirkungsgleiche Elemente, Bereiche und Strukturen tragen gleiche Bezugszeichen. Insoweit sich Elemente, Bereiche oder Strukturen in ihrer Funktion entsprechen, wird deren Beschreibung nicht notwendigerweise in jeder der folgenden Figuren wiederholt.

In den Figuren zeigen:
- Figur 1A: bis 1C jeweils Ausführungsbeispiele eines optoelektronischen Bauelements in einer schematischen Querschnittsansicht,
- Figur 2: ein weiteres Ausführungsbeispiel einer Vielzahl von optoelektronischen Bauelementen in einer Draufsicht,
- Figur 3A: bis 3E weitere Ausführungsbeispiele zur Herstellung einer Vielzahl von optoelektronischen Bauelementen in einer schematischen Querschnittsansicht,
- Figur 4A: bis 4E ein weiteres Ausführungsbeispiel zur Herstellung einer Vielzahl von optoelektronischen Bauelementen in einer schematischen Querschnittsansicht,
- Figur 5A: ein weiteres Ausführungsbeispiel von optoelektronischen Bauelementen in einer Draufsicht,
- Figur 5B: eine schematische Querschnittsansicht von optoelektronischen Bauelementen gemäß Figur 5A,
- Figur 6: ein weiteres Ausführungsbeispiel von optoelektronischen Bauelementen in einer Draufsicht,
- Figur 7A und 7B: ein weiteres Ausführungsbeispiel zur Herstellung einer Vielzahl von optoelektronischen Bauelementen, jeweils in einer schematischen Querschnittsansicht,
- Figur 8: ein weiteres Ausführungsbeispiel einer Vielzahl von optoelektronischen Bauelementen in einer Draufsicht,
- Figur 9: eine Darstellung eines Ausführungsbeispiels einer Vielzahl von optoelektronischen Bauelementen, und
- Figur 10: ein weiteres Ausführungsbeispiel zur Herstellung einer Vielzahl von optoelektronischen Bauelementen, in einer schematischen Querschnittsansicht.

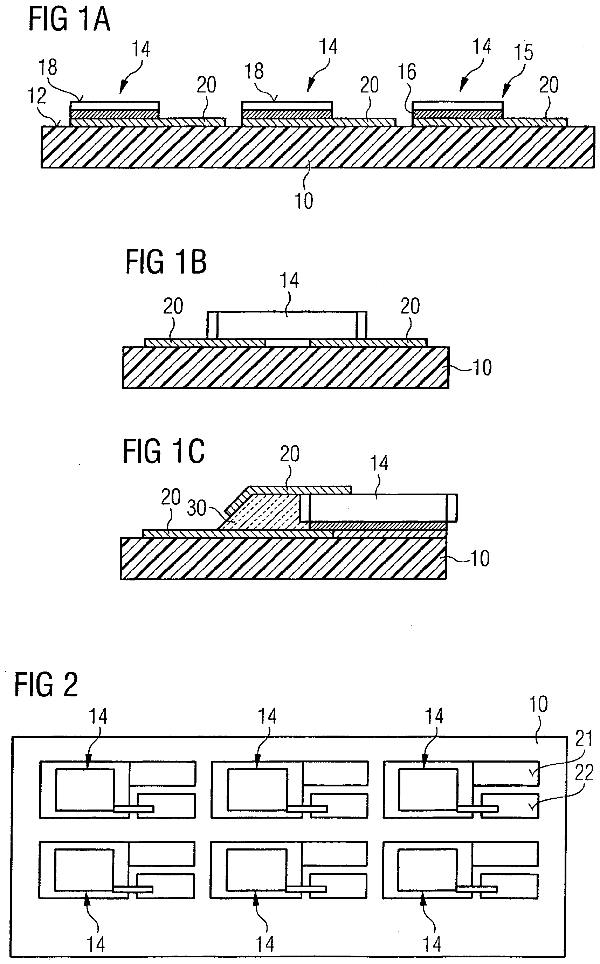

Unter Bezugnahme auf Figur 1A wird im Folgenden der Ausgangspunkt des erfindungsgemäßen Verfahrens beschrieben. Figur 1A zeigt einen Halbleiterkörperträger 10, auf dem auf einer ersten Hauptfläche 12 eine Vielzahl von Halbleiterkörpern 14 aufgebracht ist.

Die Halbleiterkörper 14 weisen jeweils eine Kontaktstruktur 20 auf, der geeignet ist, den Halbleiterkörper 14 elektrisch zu kontaktieren. Der Halbleiterkörper 14, der über der Kontaktstruktur 20 angeordnet ist, umfasst eine aktive Schicht 16, die in einer Halbleiterschichtenfolge 15 eingebettet ist. Die aktive Schicht 15 ist vorzugsweise zur Strahlungserzeugung ausgebildet. Bevorzugt ist der jeweilige Halbleiterkörper als Lumineszenzdioden-Halbleiterkörper ausgeführt.

Weiterhin umfasst der Halbleiterkörper 14 eine Halbleiterschichtenfolge 15. Die Halbleiterschichtenfolge 15 kann beispielsweise zwei Halbleiterschichten aufweisen, zwischen denen die aktive Schicht 16 angeordnet ist. Die Halbleiterschichten sind dabei vorzugsweise von unterschiedlichen Leitungstypen, insbesondere für unterschiedliche Leitungstypen dotiert (n-leitend oder p-leitend). Der Halbleiterkörper 14 ist weiterhin bevorzugt epitaktisch gewachsen.

Eine Halbleiterschichtstruktur für die Halbleiterkörper 14 kann auf einem Aufwachssubstrat epitaktisch, beispielsweise mittels metallorganischer Gasphasenepitaxie, abgeschieden sein. Aus der Halbleiterschichtstruktur können dann Halbleiterkörper beispielsweise mittels Ätzen ausgebildet werden.

Auf der Oberseite des Halbleiterkörpers 14 ist eine Strahlungsaustrittsfläche 18 gebildet, deren Fläche im Wesentlichen der Größe der Halbleiterstruktur entspricht. Der Halbleiterkörper 14 kann dabei beispielsweise rechteckförmig ausgebildet sein, wobei die Seitenlänge des Rechtecks über einen großen Bereich variieren können. So ist es zum einen möglich, Halbleiterkörper mit einer Seitenlänge von weniger als 50 µm zu bilden, es ist aber auch denkbar, großflächige Halbleiterkörper mit Seitenlängen bis zu 5 mm einzusetzen.

Die Halbleiterschichtenfolge 15 weist dabei in etwa eine Dicke von beispielsweise 6 µm auf, wobei auch dieser Wert in einem großen Bereich variieren kann. Üblicherweise handelt es sich bei der Kontaktstruktur 20 um Metallbahnen, die beispielsweise aus einer aufgesputterten Metallschicht mittels fotolithografischer Techniken erzeugt werden. Deren Dicke beträgt üblicherweise einige Mikrometer.

Das in Figur 1A gezeigte Ausführungsbeispiel stellt nur eine Variante eines Aufbaus eines Halbleiterkörpers dar. Es sind auch andere Anordnungen denkbar, die sich beispielsweise durch eine unterschiedliche Art der Kontaktierung, das heißt des Bildens des Anschlussträgers 20, von dem Ausführungsbeispiel gemäß Figur 1A unterscheiden.

So ist in Figur 1B ein Halbleiterkörper 14 gezeigt, der auf beiden Seitenflächen jeweils einen Kontakt aufweist, die mit der Kontaktstruktur 20 verbunden sind. Folglich sind die Kontakte bei diesem Ausführungsbeispiel auf gegenüberliegenden Seiten angeordnet.

Es ist aber auch denkbar, eine Kontaktierung über eine Kante des Halbleiterkörpers durchzuführen, wie in Figur 1C gezeigt.

Dazu wird der Halbleiterkörper 14 oberhalb des Halbleiterkörperträgers 10 angeordnet und auf einer Seite mit einem Isolationsmaterial 30 versehen. Die Anschlüsse an die Halbleiterschichtenfolge können dann über beziehungsweise unter dem Isolationsmaterial 30 angeordnet werden.

Die Halbleiterkörper 14 sind weiterhin bevorzugt gemäß einem regulären Muster auf dem Halbleiterkörperträger 10 angeordnet, wie in Figur 2 gezeigt ist. Anhand der in Figur 2 gezeigten Draufsicht ist zu erkennen, dass die Halbleiterkörper 14 beispielsweise in Form einer Matrix angeordnet sind.

Die Halbleiterkörper 14 können dabei in einem frei wählbaren Raster auf dem Halbleiterkörperträger 10 angeordnet werden. Die Vielzahl der Halbleiterkörper 14 kann beispielsweise von einem Waferverbund stammen, wobei die Halbleiterkörper 14 einzeln auf den Halbleiterkörperträger 10 übertragen werden. Dazu kann beispielsweise das in der Technik bekannte Pick-and-Place-Verfahren eingesetzt werden.

Demgemäß ist es möglich, Halbleiterkörper 14 des Waferverbunds bereits nach Herstellung einem Test zu unterziehen, um beispielsweise die auf dem Halbleiterkörperträger 10 anzuordnenden Halbleiterkörper 14 bezüglich ihrer Strahlungscharakteristik vorzuselektieren. Es ist aber auch denkbar, Halbleiterkörper von unterschiedlichen Waferverbünden einzusetzen, die beispielsweise unterschiedliche zur Erzeugung von elektromagnetischer Strahlung geeignete aktive Schichten 16 aufweisen, sodass die Halbleiterkörper 14 auf dem Halbleiterkörperträger 10 elektromagnetische Strahlung mit unterschiedlichen Wellenlängen abstrahlen können.

In einer anderen Ausführungsform ist es ebenfalls möglich, Halbleiterkörper von einem Waferverbund mittels eines Hilfsträgers, beispielsweise einer Folie, bevorzugt einer Thermorelease-Folie, auf den Halbleiterkörper zu übertragen. Dabei werden insbesondere Einzelbearbeitungsschritte eingespart.

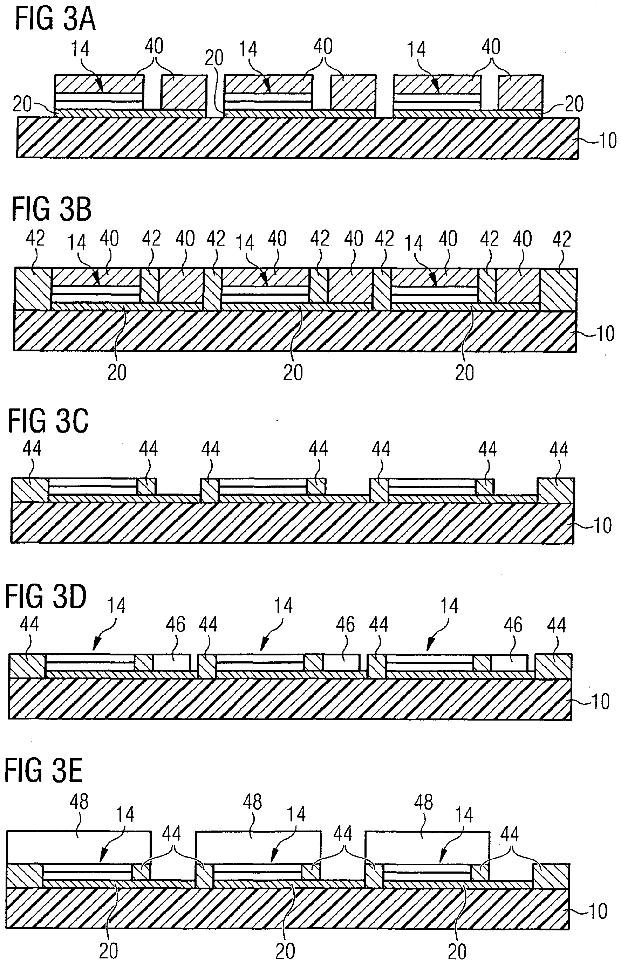

Im Folgenden wird unter Bezugnahme auf die Figuren 3A bis 3B ein erstes Ausführungsbeispiel zur Herstellung einer Vielzahl von optoelektronischen Bauelementen beschrieben.

Ausgangspunkt des Verfahrens sind dabei die in Figuren 1A bis 1C beschriebenen Halbleiterkörper 14, die auf dem Halbleiterkörperträger 10 angeordnet sind.

Wie in Figur 3A gezeigt ist, wird in einem ersten Schritt eine Fotolackschicht aufgebracht, die anschließend strukturiert wird. Die Strukturierung der Fotolackschicht kann dabei beispielsweise mit der in der Technik bekannten fotolithografischen Belichtung durchgeführt werden. Im Ergebnis erhält man eine Fotoresiststruktur 40, die die Halbleiterkörper 14 sowie Teile der Kontaktstruktur 20 bedeckt. Die Fotoresistschicht wird dabei so strukturiert, dass jeweils an den Seiten der Halbleiterkörper 14 Lehrbereiche entstehen. Die Fotoresistschicht wird dabei auch zwischen Kontaktstrukturen 20 von benachbarten Halbleiterkörpern entfernt.

Für den Halbleiterkörperträger 10 kann eine Vielzahl von Materialien verwendet werden. So ist es zum Beispiel vorgesehen, ein Keramiksubstrat oder ein Siliziumsubstrat zu verwenden. Weitere mögliche Materialien umfassen Magnesiumoxid, Aluminiumoxid, Saphir, Aluminiumnitrid oder andere dem Fachmann bekannte Materialien.

Unter Bezugnahme auf Figur 3B ist nun das Aufbringen einer Füllschicht gezeigt, die anschließend planarisiert wird. Im Ergebnis erhält man eine Füllstruktur, die in den vom Fotoresist freigelegten Teil eingebettet ist. Durch den Schritt des Planarisierens weist die Füllstruktur 42 eine im Wesentlichen identische Höhe wie die Resiststruktur 40 auf. Das Füllmaterial kann dabei beispielsweise ein Kunststoff sein. Vorzugsweise wird Benzocyclobutene verwendet.

Im nächsten Schritt, der in Figur 3C gezeigt ist, wird die Resiststruktur 40 entfernt und es wird ein weiterer Planarisierungsschritt durchgeführt. Der weitere Planarisierungsschritt vermindert die Höhe der Füllstruktur 42, sodass nunmehr eine mit der Oberseite der Halbleiterkörper 14 planare Füllstruktur 44 gebildet wird.

Demgemäß ist es nun möglich, alle weiteren Prozessschritte auf einem planaren System in einem Waferlevelverbund auszuführen. Die weiteren Prozessschritte umfassen das Bilden von Schutzdioden, das Aufbringen eines Konverters, das Bilden von Reflektorschichten oder Aufbringen von optischen Elementen, wie zum Beispiel Linsen. Es sollte jedoch erwähnt werden, dass diese weiteren Prozessschritte nicht notwendigerweise alle ausgeführt werden müssen. So ist es beispielsweise denkbar, optoelektronische Bauelemente herzustellen, die keinen Konverter benötigen oder ohne Schutzdioden betrieben werden. Folglich sind die nachfolgend gezeigten Prozessschritte nur beispielhaft zu verstehen.

In Figur 3D wird nunmehr das Bilden von Schutzdioden 46 gezeigt, die auf dem Anschlussträger 20 auf den entsprechenden ersten Kontaktflächen 21 beziehungsweise zweiten Kontaktflächen 22 angeordnet werden. Des Weiteren wird in diesem Prozessschritt auch die elektrische Verdrahtung durchgeführt.

Unter Bezugnahme auf Figur 3E wird nun das Bilden eines Konverters über der Abstrahlfläche des Halbleiterkörpers 14 gezeigt. Die Konverterschicht ist beispielsweise eine Silikonschicht, in die zumindest ein Lumineszenzkonversionsstoff eingebettet ist. Bei dem mindestens einen Lumineszenzkonversionsstoff kann es sich beispielsweise um YAG:Ce oder einen bekannten Lumineszenzkonversionsstoff handeln.

Mittels des Lumineszenzkonversionsstoffs wird beispielsweise die Wellenlänge zumindest eines Teils der aus der aktiven Schicht 12 emittierten Strahlung, die beispielsweise grünes, blaues oder ultraviolettes Licht ist, derart in einen komplementären Spektralbereich konvertiert, dass Weißlicht entsteht.

Die Verwendung einer Silikonschicht als Trägerschicht für den Lumineszenzkonversionsstoff hat den Vorteil, dass Silikon vergleichsweise unempfindlich gegen kurzwellige blaue oder ultraviolette Strahlung ist. Dies ist insbesondere vorteilhaft für auf Nitridverbindungshalbleitern basierende Lumineszenzdiodenchips, bei denen die emittierte Strahlung in der Regel zumindest einen Anteil aus dem kurzwelligen blauen oder ultravioletten Spektralbereich enthält. Alternativ kann auch ein andere transparentes organisches oder anorganisches Material als Trägerschicht für den mindestens einen Lumineszenzkonversionsstoff fungieren.

Weitere Prozess-Schritte umfassen das Aufbringen einer Kontaktschicht als reflektierende Kontaktschicht. Des Weiteren kann zwischen einer Kontaktschicht 20 und einer Verbindungsschicht eine Barriereschicht angeordnet sein. Die Barriereschicht enthält beispielsweise TiWN. Durch die Barriereschicht ist insbesondere eine Diffusion von Material der Verbindungsschicht, die beispielsweise eine Lotschicht ist, in die reflektierende Kontaktschicht verhindert, durch die insbesondere die Reflektion der reflektierenden Kontaktschicht beeinträchtigt werden könnte. Diese Schritte sind dem kundigen Fachmann jedoch bekannt und werden deshalb nicht ausführlich beschrieben.

Der Konverter kann beispielsweise auf einer Trägerfolie bereitgestellt werden und in einem Schritt auf jeweils einen Halbleiterkörper der Vielzahl von optoelektronischen Bauelementen übertragen werden. Folglich werden zeitaufwändige Einzelbearbeitungsschritte an einzelnen optoelektronischen Bauelementen eingespart. Für das Konvertermaterial des Konverters 48 sind in der Technik unterschiedliche Herstellungsverfahren bekannt.

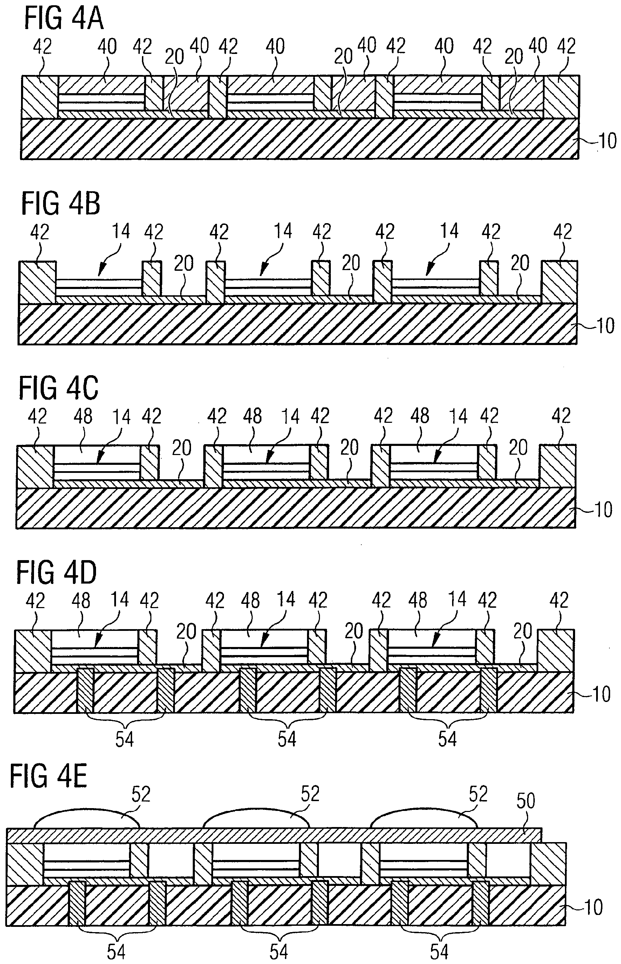

Unter Bezugnahme auf die Figuren 4A bis 4E wird im Folgenden ein zweites Ausführungsbeispiel des Verfahrens zur Herstellung einer Vielzahl von optoelektronischen Bauelementen beschrieben.

Das Verfahren gemäß den Figuren 4A bis 4E unterscheidet sich vom vorstehend beschriebenen Verfahren dadurch, dass der Schritt des weiteren Planarisierens der Füllstruktur entfällt. Folglich ragt die Resiststruktur über die Strahlungsaustrittsfläche des Halbleiterkörpers hinaus, sodass über diesem ein Hohlraum entsteht.

Dieser Hohlraum kann im Folgenden genutzt werden, wie in Figur 4C gezeigt ist, um den Konverter 48 einzufüllen. Dazu wird vorteilhaft ein Konvertermaterial verwendet, das in einem flüssigen Aggregatszustand vorliegt und nach dem Einfüllen in die Hohlräume aushärtet. Des Weiteren ist es ebenso vorgesehen, zwischen der Strahlungsaustrittsfläche und dem Konverter eine Lücke zu lassen oder eine Abdeckung vorzusehen. Dies hat insbesondere thermische Vorteile bei Verwendung von optoelektronischen Bauelementen, die im ultravioletten Bereich Strahlung aussenden.

Eine weitere Variante betrifft die Figur 4D. Dort ist es gezeigt, die Kontaktflächen 21, 22 der Kontaktstruktur 20 von der der ersten Hauptfläche 12 entgegengesetzten Seite mittels Durchkontaktierungen 54 (so genannten Vias) zu kontaktieren. Demgemäß ist es möglich, optoelektronische Bauelemente herzustellen, die sich für eine Oberflächenmontage eignen.

Eine weitere, in Figur 3 oder 4 nicht gezeigte Variante betrifft das Bilden von Schutzdioden. Insbesondere bei Verwendung eines Siliziumsubstrats als Halbleiterkörperträger 10 kann beispielsweise durch geeignete Dotierung eine Schutzdiode direkt im Halbleiterkörper 10 gebildet werden. Durch entsprechende Dimensionierung, das heißt Anpassung der Größe der dotierten Bereiche, lässt sich die elektrische Charakteristik der Schutzdiode auf den jeweiligen Anwendungsfall anpassen.

Diese Variante spart insbesondere die kostenintensive Bestückung mit externen Schutzdioden, wie in Figur 3D gezeigt wurde.

Unter Bezugnahme auf Figur 4E ist gezeigt, über die optoelektronischen Bauelemente eine Optik aufzubringen. Die Optik kann dabei aus einer Vielzahl von Linsen 52 bestehen, die auf einem Träger 50 angeordnet sind. Demgemäß wird nun für jeden der optoelektronischen Halbleiterkörper auf dem Halbleiterkörperträger 10 in einem einzigen Prozessschritt eine Linse 52 gebildet.

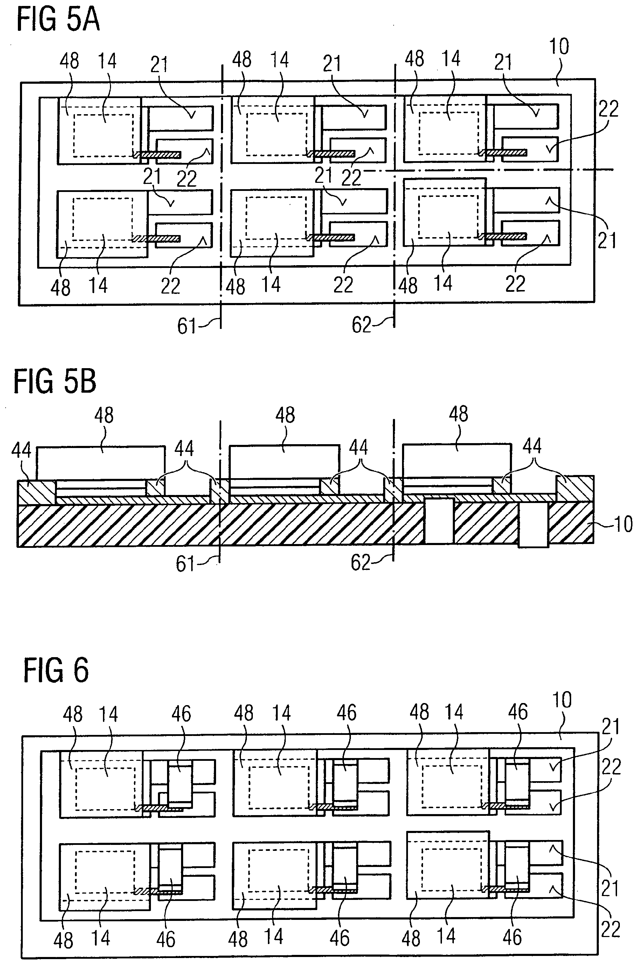

Im Folgenden wird unter Bezugnahme auf die Figuren 5A und 5B ein weiteres Ausführungsbeispiel der Erfindung gezeigt. Die gezeigten Prozessschritte schließen sich dabei an die Verfahrensschritte gemäß den Figuren 3A bis 3E oder Figuren 4A bis 4E an.

Wie in Figur 5A gezeigt ist, ist es nun möglich, die Vielzahl von optoelektronischen Bauelementen, die in einem regelmäßigen Muster auf dem Halbleiterkörperträger 10 angeordnet sind, zu vereinzeln.

Dabei wird der Halbleiterkörper 10 sowohl horizontal als auch vertikal im Bezug auf die Zeichenebene der Figur 5A zerschnitten. Wie in Figur 5A gezeigt ist, können dabei beispielsweise Module gebildet werden, die einen oder zwei Lumineszenzdiodenchips enthalten.

Dazu werden beispielsweise Schnitte durch das Füllmaterial zwischen benachbarten Halbleiterkörpern 14 durchgeführt, wie in Figur 5B anhand der Schnittlinien 61 und 62 schematisch eingezeichnet ist.

In Figur 6 ist in einem weiteren Ausführungsbeispiel die Bestückung mit Schutzdioden 46 näher erläutert. Die Schutzdioden 46 werden beispielsweise mittels eines Oberflächenmontageverfahrens auf den ersten Kontaktflächen 21 und den zweiten Kontaktflächen 22 angeordnet. Das Anbringen der Schutzdioden 46 wird dabei vorteilhafterweise vor dem Vereinzeln der optoelektronischen Bauelemente durchgeführt.

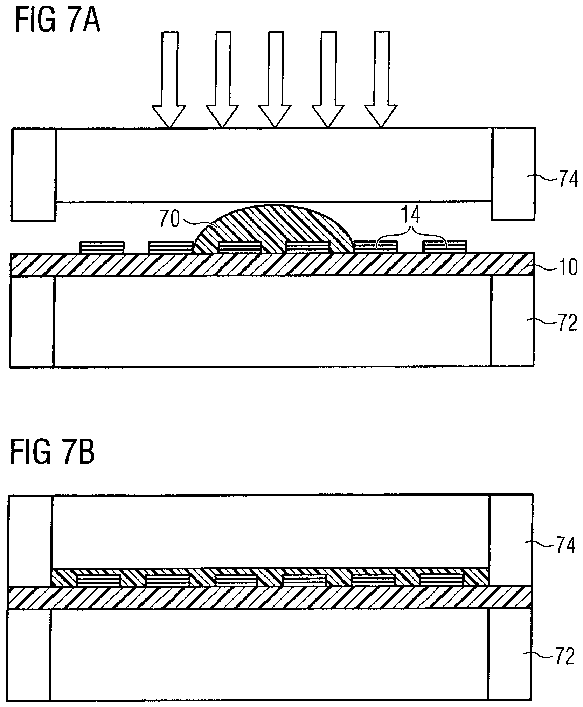

Im Folgenden wird unter Bezugnahme auf die Figuren 7A und 7B eine weitere Variante beschrieben.

Diese Variante betrifft das Aufbringen des Füllmaterials, das gemäß diesem Ausführungsbeispiel aus einer Vergussmasse besteht. Dazu wird der Halbleiterkörperträger 10 mit der Vergussmasse 70 versehen. Diese kann beispielsweise in Tropfenform aufgebracht werden.

Der Halbleiterkörperträger 10 wird zwischen zwei Werkstücke 72 und 74 eingebracht, wobei die beiden Werkstücke geheizt werden. Dabei hat das obere Werkstück 74 eine Öffnung (Kavität), um die Halbleiterkörper 14 auf dem Halbleiterkörperträger 10 nicht zu berühren. Durch Verpressen wird nun die Vergussmasse 70 zwischen die Halbleiterkörper 14 gepresst. Nach einem Planarisierungsschritt schließt sich die weitere Prozessführung an die Beschreibung der Figuren 3B beziehungsweise 4B an.

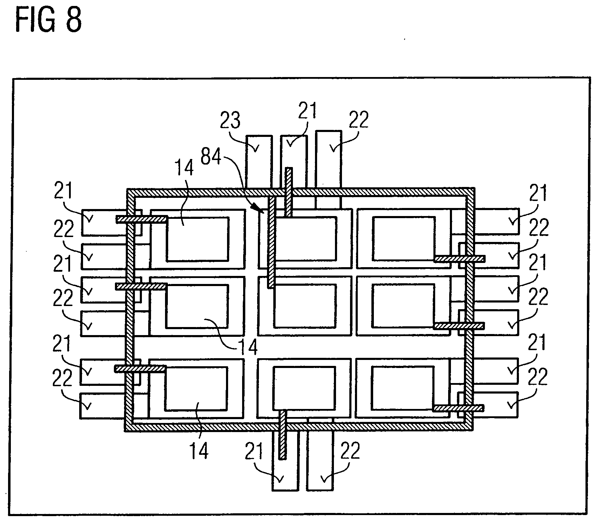

In Figur 8 ist eine weitere Ausführungsform gezeigt, bei der die Vielzahl von optoelektronischen Bauelementen auf einem gemeinsamen Verbindungsträger aufgebracht ist.

Wie in Figur 8 zu sehen ist, werden dabei die außen liegenden Halbleiterkörper 14 jeweils mit Anschlussflächen 21 beziehungsweise 22 versehen. Der im Inneren der Anordnung liegende Halbleiterkörper wird mittels eines Brückenkontaktes 84, der über die Leiterbahn des darüber angeordneten Chips läuft, auf ein Kontaktfeld 23 geführt.

Gemäß dieser Ausführungsform ist es möglich, beliebig große Module zu schaffen, die aus einer Vielzahl von optoelektronischen Bauelementen bestehen. Wie vorstehend beschrieben wurde, ist es nunmehr möglich, optoelektronische Bauelemente zu bilden, ohne eine Vielzahl von Einzelbearbeitungsschritten durchführen zu müssen.

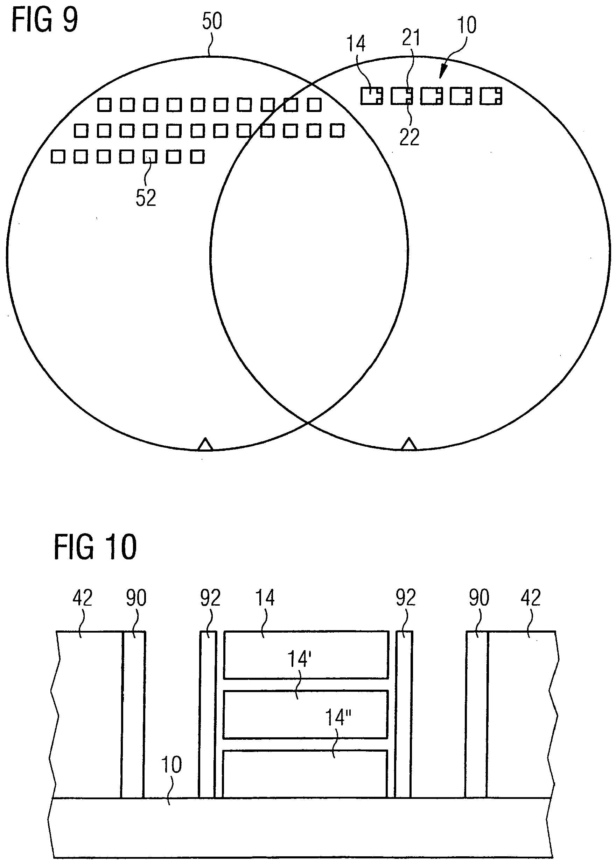

Dies wird zusammenfassend noch mal unter Bezugnahme auf Figur 9 erläutert, wo ein Halbleiterkörperträger 10 gezeigt ist, der eine Vielzahl von optoelektronischen Bauelementen umfasst. Der Halbleiterkörperträger 10 kann beispielsweise ein 6"-Wafer sein. Auf der linken Seite wird eine Vielzahl von Linsen gezeigt, die im Waferverbund hergestellt werden. Folglich ist es möglich, beispielsweise die Anbringung von optischen Elementen, über den Halbleiterkörper 14 in einem einzelnen Schritt für eine Vielzahl von optoelektronischen Bauelemente auf einem Halbleiterkörperträger durchzuführen.

Ein weiteres Ausführungsbeispiel ist unter Bezugnahme auf Figur 10 gezeigt. Gemäß diesem Ausführungsbeispiel wird ein so genannter gestapelter Halbleiterkörper verwendet, der beispielsweise aus drei Halbleiterschichtenfolgen besteht, die jeweils mit unterschiedlichen aktiven Schichten versehen sind, um beispielsweise rot, grün oder blau abstrahlende Halbleiterkörper zu bilden.

Diese sind übereinander angeordnet, wobei darunter liegend eine Spiegelschicht, eine Diffusionssperre und eine Lötschicht angeordnet sein können. Auf den Seitenflanken dieses Schichtstapels kann beispielsweise eine Passivierungsschicht angeordnet werden.

Des Weiteren ist es ebenso vorgesehen, auf den Seitenflanken des Füllmaterials einen Spiegel 90 zu bilden. Dabei kann der Flankenwinkel der Seitenflanken des Füllmaterials variabel sein. Um Passivierungsschichten 92 beziehungsweise die auf den Seitenflanken angeordneten Spiegel zu bilden, kann eine Prozessführung verwendet werden, die ähnlich zu der in den Figuren 3A bis 3E beziehungsweise 4A bis 4E verläuft.

Diese Prozessführung unterscheidet sich jedoch darin, dass die beispielsweise in Figur 3A gezeigte Strukturierung der Resistschicht so durchgeführt wird, dass die Resistschicht auch die Flanken der Halbleiterkörper 14 bedeckt. Folglich entsteht nach dem Entfernen der Resiststruktur zwischen dem Halbleiterkörper 14 und der Füllstruktur eine Lücke, in die die Passivierung beziehungsweise die Spiegel eingebracht werden kann.

## Patentansprüche

1. Verfahren zur Herstellung einer Vielzahl von optoelektronischen Bauelementen, umfassend:
- Bereitstellen eines Halbleiterkörperträgers (10), der auf einer ersten Hauptfläche (12) eine Vielzahl von jeweils mit einer Kontaktstruktur (20) versehenen Halbleiterkörper (14) mit einer zur Erzeugung von elektromagnetischer Strahlung geeigneten aktiven Schicht (16) in einer Halbleiterschichtenfolge (15) umfasst, wobei die Kontaktstrukturen jeweils zumindest teilweise zwischen dem Halbleiterkörperträger und dem jeweiligen Halbleiterkörper gelegen sind, und
- Bilden einer mit einer Oberseite der Halbleiterkörper (14) planaren Füllstruktur (44) auf der ersten Hauptfläche (12), wobei die planare Füllstruktur (44) Bereiche der Kontaktstruktur (20) und den Halbleiterkörperträger (10) wenigstens teilweise abdeckt, ohne den Halbleiterkörper (14) zu bedecken, **dadurch gekennzeichnet, dass** der Schritt des Bildens der planaren Füllstruktur (44) dadurch ausgeführt wird, dass eine strukturierte Resistschicht (40) gebildet wird, die zumindest den Halbleiterkörper (14) bedeckt, die planare Füllstruktur (44) außerhalb der strukturierten Resistschicht (40) gebildet wird und die strukturierte Resistschicht (40) entfernt wird.

2. Verfahren nach Anspruch 1,
bei dem das planare Füllmaterial in einem Abstand zu wenigstens einer Seitenflanke der Halbleiterkörper angeordnet wird, um seitlich der Halbleiterkörper eine Spiegelschicht zu bilden.

3. Verfahren nach einem der vorhergehenden Ansprüche, bei dem das Füllmaterial Kunststoff, vorzugsweise Benzocyclobutene umfasst.

4. Verfahren nach einem der vorhergehenden Ansprüche, bei dem ein oder mehrere optoelektronische Bauelemente durch Trennen des Halbleiterkörperträgers vereinzelt werden.

## Claims

1. Method for producing a multiplicity of optoelectronic components, comprising:
- providing a semiconductor body carrier (10), which comprises, on a first main area (12) a multiplicity of semiconductor bodies (14) each provided with a contact structure (20) and having an active layer (16) suitable for generating electromagnetic radiation, in a semiconductor layer sequence (15), wherein the contact structures are placed in each case at least partly between the semiconductor body carrier and the respective semiconductor body, and
- forming a filling structure (44) which is planar with a top side of the semiconductor bodies (14) on the first main area (12), wherein the planar filling structure (44) at least partly covers regions of the contact structure (20) and the semiconductor body carrier (10), without covering the semiconductor body (14), **characterized in that** the step of forming the planar filling structure (44) is performed by forming a patterned resist layer (40) that covers at least the semiconductor body (14), forming the planar filling structure (44) outside the patterned resist layer (40), and removing the patterned resist layer (40).

2. Method according to claim 1,
wherein the planar filling material is arranged at a distance from at least one sidewall of the semiconductor bodies in order to form a mirror layer laterally with respect to the semiconductor bodies.

3. Method according to any of the preceding claims,
wherein the filling material comprises plastic, preferably benzocyclobutene.

4. Method according to any of the preceding claims,
wherein one or a plurality of optoelectronic components is/are singulated by separation of the semiconductor body carrier.

## Revendications

1. Procédé destiné à la fabrication d'une pluralité de composants optoélectroniques, comprenant :
- la mise en place d'un support de corps semiconducteurs (10) qui comprend une pluralité de corps semiconducteurs (14) sur une première surface principale (12), lesquels sont respectivement pourvus d'une structure de contact (20), avec une couche (16) active qui se prête à la production d'un rayonnement électromagnétique, dans une série de couches semiconductrices (15);
selon lequel les structures de contact sont positionnées respectivement entre le support de corps semiconducteurs et le corps semiconducteur respectif, tout au moins en partie ; et
- la formation d'une structure de remplissage (44) planaire avec une face supérieure des corps semiconducteurs (14) sur la première surface principale (12) ;
selon lequel la structure de remplissage (44) planaire recouvre, tout au moins en partie, des zones de la surface de contact (20) ainsi que le support de corps semiconducteurs (10), sans pour autant recouvrir le corps semiconducteur (14) ;
**caractérisé en ce que** la phase de la formation de la structure de remplissage (44) planaire est réalisée de telle sorte qu'une couche de protection (40) structurée est formée, laquelle recouvre tout au moins le corps semiconducteur (14), de telle sorte que la structure de remplissage (44) planaire est formée à l'extérieur de la couche de protection (40) structurée et de telle sorte que la couche de protection (40) structurée est éliminée.

2. Procédé selon la revendication 1,
pour lequel la matière de remplissage planaire est disposée à une certaine distance de tout au moins un flanc latéral des corps semiconducteurs, en vue de former une couche réfléchissante de manière latérale par rapport aux corps semiconducteurs.

3. Procédé selon l'une des revendications précédentes, pour lequel la matière de remplissage comprend une matière plastique, de préférence du benzocyclobutène.

4. Procédé selon l'une des revendications précédentes, pour lequel un ou plusieurs composants optoélectroniques sont divisés par la séparation du support de corps semiconducteurs.
